# EUROPÄISCHE PATENTSCHRIFT

(11) **EP 2 391 902 B1**
(45) Veröffentlichungstag und Bekanntmachung des Hinweises auf die Patenterteilung: **22.08.2012**
(21) Anmeldenummer: 10700545.6
(22) Anmeldetag: 13.01.2010
(51) Int. Cl.: G01R 31/42, H02P 29/02

(54) **Verfahren zum Betrieb eines bürstenlosen Motors**
Method for operating a brushless motor
Procédé de fonctionnement d'un moteur sans balais

(30) Priorität: 28.01.2009 DE 102009000448
(43) Veröffentlichungstag der Anmeldung: 07.12.2011
(73) Patentinhaber: Continental Automotive GmbH, 30165 Hannover (DE)
(72) Erfinder: DONNER, Andreas, 60316 Frankfurt (DE); GUNSELMANN, Christian, 42113 Wuppertal (DE)
(86) Internationale Anmeldenummer: PCT/EP2010/050354
(87) Internationale Veröffentlichungsnummer: WO 2010/086227

(56) Entgegenhaltungen:
- EP-A1- 1 387 459
- EP-A2- 1 959 561

## Beschreibung

Die vorliegende Erfindung betrifft ein Verfahren zum Betrieb eines bürstenlosen Elektromotors, dessen Wicklungen von einem Wechselrichter mit Hilfe von sechs Schalter angesteuert werden, wobei eine Erkennungseinheit zum Erkennen von defekten Schaltern, eine Einheit zur Spannungsmessung an den Ausgängen des Wechselrichters und ein Mikrocontroller zum Steuern der Schalter vorgesehen ist.

Wechselrichter zur Ansteuerung bürstenloser Motoren bestehen in der Regel aus sechs Schaltern. Jeder Schalter kann nach einem Defekt prinzipiell zwei verschiedene Eigenschaften aufweisen: Nicht leitend, das heißt in der geöffneten Schalterstellung blockiert, oder leitend, das heißt in der geschlossenen Schalterstellung blockiert. Ein leitend defekter Schalter ist umgangssprachlich auch als Kurzschluss bekannt. Besonders in sicherheitsrelevanten Anwendungen ist es dann wichtig, sehr schnell zu ermitteln, welche Art des Defekts vorliegt, um den Elektromotor in einem Notbetrieb weiter zu betreiben oder sofort abzuschalten.

Häufig werden Stromsensoren eingesetzt, mit denen der Strom der einzelnen Motorphasen oder der Gesamtstrom gemessen werden kann. Mit Hilfe von Stromsensoren ist zwar eine Unterscheidung zwischen leitend defekten und nicht leitend defekten Schaltern möglich und somit die Art des Defekts ermittelbar, allerdings müssen die Kosten für die Stromsensoren berücksichtigt werden. Alternativ kann bei einem defekten Schalter der Elektromotor stets abgeschaltet werden. Ein Notbetrieb ist dann nicht möglich.

Aus der EP 1 959 561 A2 ist ein Verfahren der eingangs genannten Gattung bekannt. Bei dem vorbekannten Verfahren zum Betrieb eines bürstenlosen Elektromotors, werden die Wicklungen des Elektromotors von einem Wechselrichter mit Hilfe von sechs Schaltern angesteuert. Eine Erkennungseinheit zum Erkennen von defekten Schaltern, eine Einheit zur Spannungsmessung an den Ausgängen des Wechselrichters und ein Mikrocontroller zum Steuern der Schalter sind ebenfalls vorgesehen. Bei dem vorbekannten Verfahren werden Diagnosemittel eingesetzt, die eine Wicklung mit einem Spannungswert beaufschlagen. Eine nachfolgend vorgenommene Messung der Spannung wird in die Größenordnungen hoch oder niedrig eingeordnet und auf Grundlage der gemessenen Spannungswerte wird eine Unregelmäßigkeit ermittelt.

Aus der DE 11 2004 002 642 T5 ist eine Plausibilitätsprüfung eines elektrischen Drei-Phasen-Systems bekannt. Um Defekte zuverlässig zu erkennen, ist eine Messung der Phasenströme vorgesehen. Um keiner Verwechslung der Phasenströme zu unterliegen, wird darüber hinaus ein Stromraumzeiger beobachtet. Zur Durchführung des vorbekannten Verfahrens sind daher vergleichsweise teure Stromsensoren notwendig.

Der vorliegenden Erfindung liegt daher die Aufgabe zugrunde, eine schnelle und kostengünstige Ermittlung der Defektart unter Ausschluss der Verwendung von Stromsensoren zu gewährleisten.

Diese Aufgabe wird durch die Merkmale des Anspruchs 1 gelöst. Dabei wird die vom Defekt betroffene Wicklung lokalisiert und die Art des Defekts der Schalter ermittelt, indem die Wicklungen, die nicht dem defekten Schalter zugeordnet sind, mit einer unterschiedlichen Spannung angesteuert werden, während an der Wicklung, die dem defekten Schalter zugeordnet ist, eine Spannungsmessung durchgeführt wird. Die Art des Defekts ist ein in der geöffneten oder geschlossenen Schalterstellung blockierter Schalter.

Vorteilhafte Weiterbildungen sind den Unteransprüchen entnehmbar.

So wird in einer bevorzugten Weiterbildung des erfindungsgemäßen Verfahrens die dem defekten Schalter (13, 16) zugeordnete Wicklung (U) mit der Einheit (B) zur Spannungsmessung verbunden. Folgenden Schritte sind bei dem erfindungsgemäßen Verfahren vorgesehen:
- Erkennen eines defekten Schalters durch die Erkennungseinheit;
- Öffnen aller Schalter;
- Ansteuern der Wicklungen, die dem defekten Schalter nicht zugeordnet sind mit unterschiedlichen Spannungen und
- Messen und Auswerten der an der Wicklung anliegenden Spannung, die dem defekten Schalter zugeordnet ist.

Dabei ist vorgesehen, dass eine Wicklung, die dem defekten Schalter nicht zugeordnet ist, mit einer pulsweitenmodulierten Spannung beaufschlagt wird, die ein Tastverhältnis von 1/3=33% aufweist während die andere Wicklung, die dem defekten Schalter ebenfalls nicht zugeordnet ist, mit einer pulsweitenmodulierten Spannung beaufschlagt wird, die ein Tastverhältnis von 2/3=66% aufweist.

Der Schalter wird als defekt in der geöffneten Schalterstellung erkannt, wenn das Messergebnis der pulsweitenmodulierten Spannung an der Wicklung, die dem defekten Schalter zugeordnet ist, ein Tastverhältnis zwischen 33% und 66% ergibt.

Außerdem wird der Schalter als defekt in der geschlossenen Schalterstellung mit Verbindung zur positiven Versorgungspannung erkannt, wenn das Messergebnis der pulsweitenmodulierten Spannung an der Wicklung, die dem defekten Schalter zugeordnet ist, ein Tastverhältnis von 100% ergibt.

Bei einer weiteren Defektart wird der Schalter als defekt in der geschlossenen Schalterstellung mit Verbindung zur negativen Versorgungsspannung erkannt, wenn das Messergebnis der pulsweitenmodulierten Spannung an der Wicklung, die dem defekten Schalter zugeordnet ist, ein Tastverhältnis von 0% ergibt.

In einer besonders vorteilhaften Weiterbildung des erfindungsgemäßen Verfahrens werden zwei andere Wicklungen angesteuert und anschließend die beschriebenen Verfahrensschritte so lange wiederholt bis der Defekt lokalisiert ist oder ein Mehrfachfehler erkannt wird bei dem mehrere Schalter defekt sind. Die Verfahrensschritte werden also so lange mit der Ansteuerung unterschiedlicher Wicklungen wiederholt bis der Defekt lokalisiert ist oder ein Mehrfachfehler erkannt wird.

Eine weitere vorteilhafte Weiterbildung des erfindungsgemäßen Verfahrens sieht vor, dass der defekte Schalter für den Fall, dass der defekte Schalter im leitenden Zustand blockiert ist, durch eine gezielte thermische Überlast geöffnet wird. Alternativ wird eine Sicherung geöffnet, falls der defekte Schalter in der geschlossenen Schalterstellung blockiert ist. Anschließend kann der Elektromotor in einem Notbetrieb betrieben werden. Im Fall eines defekten Schalters im nichtleitenden Zustand kann der Elektromotor grundsätzlich in einem Notbetrieb betrieben werden.

Die Erfindung wird nachfolgend anhand eines Ausführungsbeispiels im Zusammenhang mit der beiliegenden Zeichnung näher erläutert. In der Zeichnung zeigen:
- Fig. 1: eine schemätische Prinzipdarstellung der Wicklunggen eines burstenlosen Elektromotors und eines Wechselrichters an der das erfindungsgemäße Verfahren durchgeführt werden kann;
- Fig. 2: eine schematische Darstellung der Wicklungen aus Fig. 1 und eine erste Defektart F₁ nicht leitend defekt eines Schalters;
- Fig. 3: eine Fig. 2 entsprechende Darstellung mit einer zweiten Defektart F₂ leitend defekt mit Verbindung zur positiven Versorgungsspannung
- Fig. 4: eine weitere Darstellung, die der Darstellung aus Fig. 2 entspricht mit einer dritten Defektart F₃ leitend defekt mit Verbindung zur negativen Versorgungsspannung und
- Fig. 5: ein Ablaufdiagramm des erfindungsgemäßen Verfahrens.

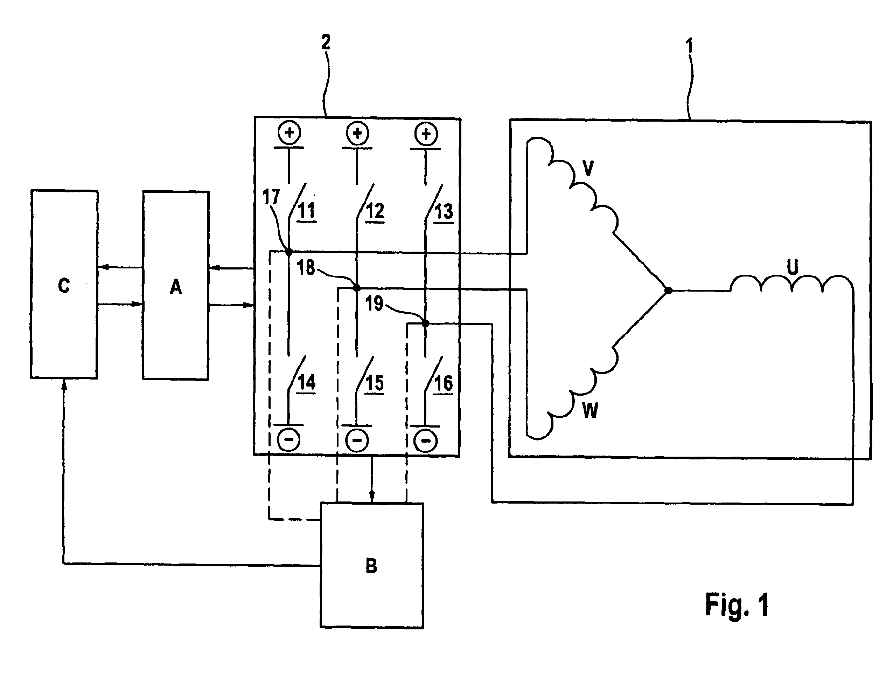

In Fig. 1 ist schematisch ein bürstenloser Elektromotor 1 dargestellt, dessen Wicklungen U, V, W von einem Wechselrichter 2 angesteuert werden. Zu diesem Zweck weist der Wechselrichter 2 sechs Schalter 11, 12, 13, 14, 15, 16 auf, wobei die in Fig. 1 oberen Schalter 11, 12, 13 der positiven Versorgungsspannung und die in Fig. 1 unteren Schalter 14, 15, 16 der negativen Versorgungsspannung zugeordnet sind. So versorgen beispielsweise die Schalter 11 und 14 die Wicklung V mit einer geeigneten Versorgungsspannung. Wie Fig. 1 weiter entnehmbar ist, befinden sich zwischen den Schaltern 11, 12, 13, die der positiven Versorgungsspannung zugeordnet sind, und den Schaltern 14, 15, 16, die der negativen Versorgungsspannung zugeordnet sind, Abgreifpunkte 17, 18, 19, an denen die an den Wicklungen U, V, W anliegende Spannung abgegriffen wird und einer Einheit B zur Spannungsmessung zugeführt wird. Die Messergebnisse der Einheit B zur Spannungsmessung werden einem Mikrocontroller C zugeführt, der seinerseits die Schalter 11, 12, 13, 14, 15, 16 steuert und andererseits die von der Spannungsmessungseinheit B erzeugten Informationen auswertet. Außerdem ist eine Erkennungseinheit A zum Erkennen von defekten Schaltern 11, 12, 13, 14, 15, 16 vorgesehen. Die von der Erkennungseinheit A erzeugten Informationen werden ebenfalls dem Mikrocontroller C zur Auswertung zugeführt.

In einer Ausführungsform in der Praxis werden die Schalter 11, 12, 13, 14, 15, 16 durch Halbleiterschalter bzw. Transistoren oder MOSFETs gebildet. Die Erkennungseinheit A ist in der Praxis als Brückentreiber ausgebildet und legt an die als Transistoren ausgebildeten Schalter 11, 12, 13, 14, 15, 16 eine Spannung an und kontrolliert, ob die Schalterstellung des Transistors wechselt. Die Einheit B zur Spannungsmessung an den Abgreifpunkten 17, 18, 19 ist in der Praxis als Spannungsteiler ausgebildet und ermittelt das Tastverhältnis einer pulsweitenmodulierten Spannung. Das Tastverhältnis entspricht dabei dem Quotienten aus Impulsdauer und Periodendauer.

Jeder Schalter 11, 12, 13, 14, 15, 16 kann prinzipiell zwei verschiedene Arten eines Defekts aufweisen bzw. befindet sich nach einem Defekt grundsätzlich in einer der beiden nachfolgend beschrieben Zustände: Nicht leitend defekt, das heißt in der geöffneten Schalterstellung blockiert, oder leitend defekt, das heißt in der geschlossenen Schalterstellung blockiert. Ein leitend defekter Schalter 11, 12, 13, 14, 15, 16 ist umgangssprachlich auch als Kurzschluss bekannt.

Besonders in sicherheitsrelevanten Anwendungen ist es wichtig, sehr schnell den Defekt zu lokalisieren und zu ermitteln, welche Art des Defekts vorliegt, um den Elektromotor 1 in einem Notbetrieb weiter zu betreiben oder sofort abzuschalten. Für den Fall, dass sich der Schalter 11, 12, 13, 14, 15, 16 im Zustand "leitend defekt" befindet, kann der Schalter 11, 12, 13, 14, 15, 16 durch eine gezielte thermische Überlast geöffnet werden, um einen Notbetrieb des Elektromotors 1 zu ermöglichen. Alternativ kann eine Sicherung geöffnet werden, falls der defekte Schalter 11, 12, 13, 14, 15, 16 im leitenden Zustand blockiert ist. Ein Notbetrieb ist nur möglich wenn sich ein Schalter 11, 12, 13, 14, 15, 16 im defekten Zustand "nicht leitend" befindet oder der Kurzschluss durch einen im leitenden Zustand blockierten Schalter aufgehoben ist.

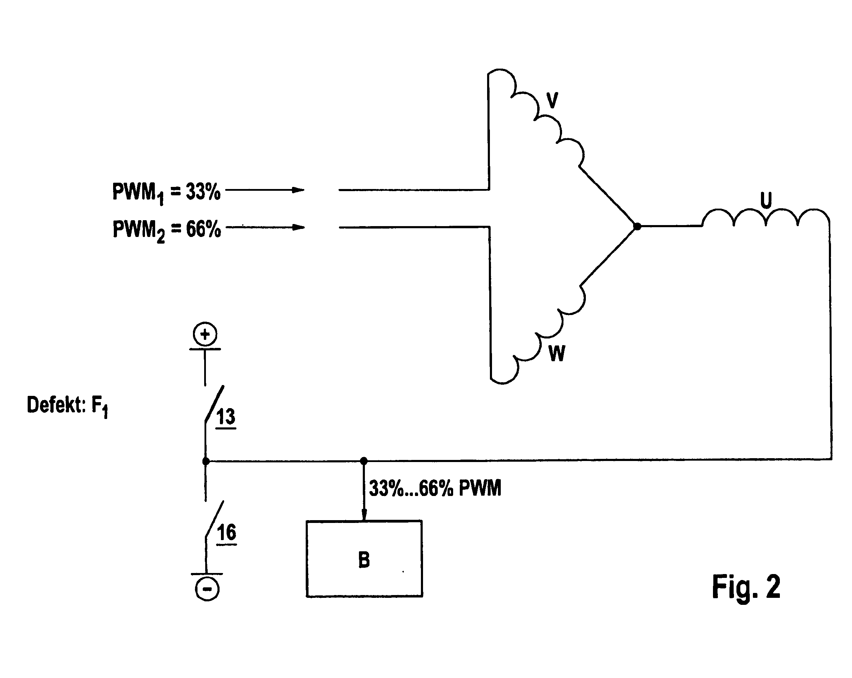

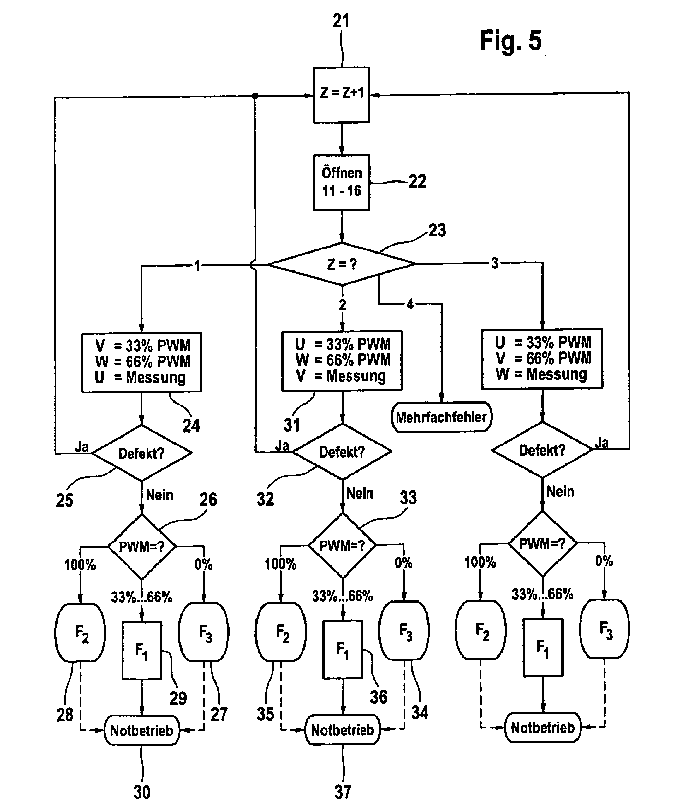

In der Fig. 2 ist der Defekt F₁ des Schalters 13 dargestellt: Der Schalter 13 ist nicht leitend defekt, d.h. der Schalter 13 ist in der geöffneten Schalterstellung blockiert. Der defekte Schalter 13 ist der Wicklung U des Elektromotors 1 zugeordnet. Um nun also den Defekt F₁ zu lokalisierten und die Art des Defekt, also leitend defekt oder nicht leitend defekt, zu ermitteln wird wie folgt vorgegangen: Zunächst erkennt die Erkennungseinheit A einen defekten Schalter 11, 12, 13, 14, 15, 16. Die Erkennungseinheit A kann aber nicht erkennen, welcher der Schalter 11, 12, 13, 14, 15, 16 defekt ist, weshalb das nachfolgende Verfahren mehrfach durchlaufen wird, wie nachfolgend noch näher anhand von Fig. 5 erläutert wird.

Anschließend wird zunächst die Ansteuerung der Schalter 11, 12, 13, 14, 15, 16 gestoppt. Alle Schalter 11, 12, 13, 14, 15, 16 werden geöffnet und damit in den Zustand "nicht leitend" überführt. Zu diesem Zweck wertet der Mikrocontroller C die Information der Erkennungseinheit A aus und generiert die für den Zustand "nicht leitend" benötigten Ansteuersignale. Der Mikrocontroller C steuert die Schalter 11, 12, 14, 15 für die beiden Wicklungen V und W, die dem defekten Schalter 13 nicht zugeordnet sind an. Die Wicklungen V und W werden dabei jeweils mit einer pulsmodulierten Spannung angesteuert, deren Tastverhältnis unterschiedlich ist. In der in Fig. 2 beschriebenen Fall wird die Wicklung V mit einem Tastverhältnis von PWM₁=1/3=33% angesteuert während die Wicklung W mit einem Tastverhältnis von PWM₂=2/3=66% angesteuert wird.

Anschließend wird eine gewisse Zeit abgewartet, um zu ermitteln, ob die Erkennungseinheit A weiterhin einen Defekt erkennt. Für den Fall, dass der defekte Schalter 11, 12, 13, 14, 15, 16 einer der angesteuerten Wicklungen V, W zugeordnet wäre, würde die Erkennungseinheit A erneut einen Defekt erkennen und die Ansteuerung anbrechen. In einem solchen Fall wird das eben beschriebene Verfahren neu gestartet und zwei andere Wicklungen U, V, W in der Hoffnung angesteuert, die beiden der insgesamt drei Wicklungen U, V, W gefunden zu haben, deren zugeordnete Schalter 11, 12, 13, 14, 15, 16 keinen Defekt aufweisen.

Anschließend misst die Einheit B zur Spannungsmessung das Tastverhältnis der pulsweitenmodulierten Spannung an der nicht angesteuerten Wicklung U und der Mikrocontroller C wertet diese Messung aus. Liegt der an der Wicklung U ermittelte Wert im Bereich zwischen PWM₁= 33% und PWM₂=66%, so wird erkannt, dass der defekte Schalter 13 nicht leitend defekt ist und der nicht angesteuerten Wicklung U zugeordnet ist.

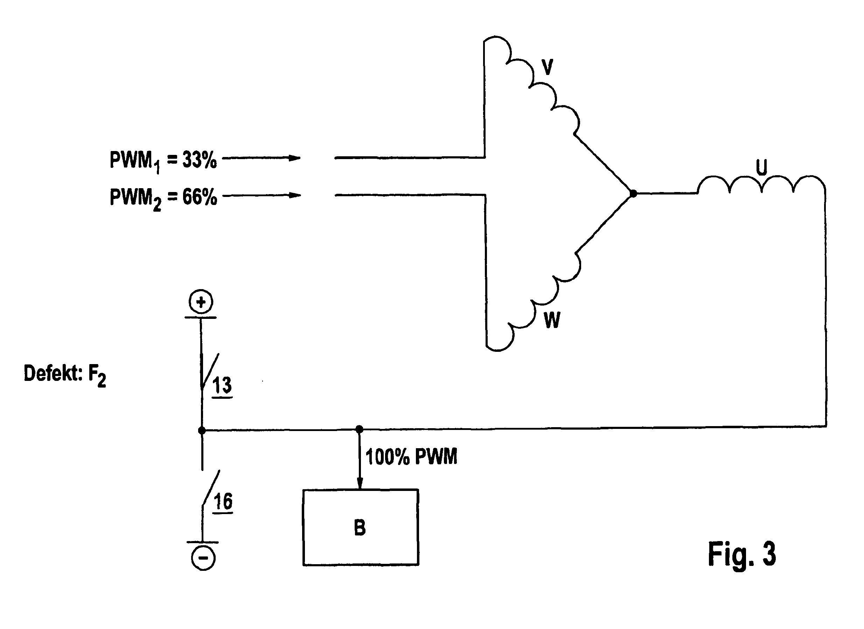

In Fig. 3 ist eine weitere Defektart schematisch dargestellt: Bei einem Defekt F₂ ist der Schalter 13 (bzw. 11 oder 12) leitend defekt mit Verbindung zur positiven Versorgungsspannung. Der Schalter 13, der der positiven Versorgungsspannung zugeordnet ist, ist bei der Defektart F₂ also in der geschlossenen Schalterstellung blockiert. Wiederum werden nach einem Öffnen aller Schalter 11, 12, 13, 14, 15, 16 die beiden Wicklungen V und W angesteuert, die dem defekten Schalter 13 nicht zugeordnet sind. Die Wicklung V wird wieder mit einer pulsweitenmodulierten Spannung mit einem Tastverhältnis von PWM₁=33% angesteuert während die Wicklung W mit einer pulsweitenmodulierten Spannung mit einem Tastverhältnis von PWM₂=66% angesteuert wird. Die Einheit B misst im in Fig. 3 beschriebenen Fall eine an der Wicklung U anliegende Spannung mit einem Tastverhältnis von 100%. Bei einem derartigen Messergebnis wird also ein leitend defekter Schalter 13 mit Verbindung zur positiven Versorgungsspannung erkannt, der derjenigen Wicklung U zugeordnet ist, die nicht angesteuert wurde.

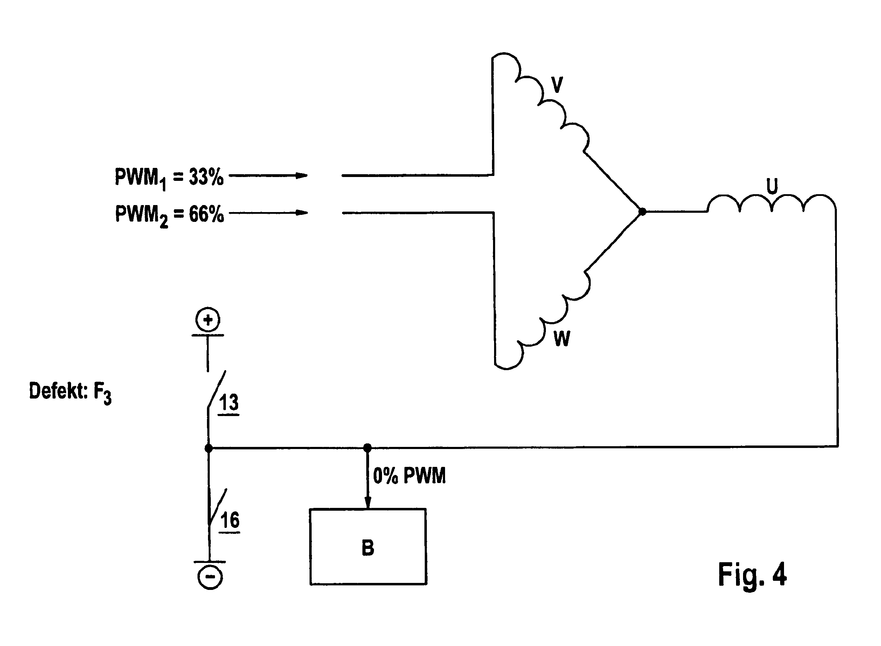

Die dritte Defektart F₃ ist in Fig. 4 schematisch dargestellt. Diese Defektart F₃ ist ein leitend defekter Schalter 16 (bzw. 14 oder 15) mit Verbindung zur negativen Versorgungsspannung. Das heißt, dieser Schalter 16 ist in der geschlossenen Schalterstellung mit Verbindung zur negativen Versorgungsspannung blockiert. Es werden wiederum die beiden Wicklungen V, W, die dem defekten Schalter 16 nicht zugeordnet sind, mit einer unterschiedlichen Spannung beaufschlagt und zwar die Wicklung V mit einer pulsweitenmodulierten Spannung mit einem Tastverhältnis von PWM₁=33% und die Wicklung W mit einem Tastverhältnis von PWM₂=66%. Die Spannungsmessung am Abgriff 19 in Fig. 1 ergibt für die Wicklung U ein Messergebnis von PWMₘₑₛₛ=0%. Mit anderen Worten wird bei einem Messergebnis von PWMₘₑₛₛ=0% erkannt, dass es sich um einen leitend defekten Schalter 16 mit Verbindung zur negativen Versorgungsspannung handelt, der der nicht angesteuerten Wicklung U zugeordnet ist.

Wie bereits erwähnt wird das Verfahren mehrfach durchlaufen, da man zu Beginn nicht weiß, welcher Wicklung U, V, W der defekte Schalter 11, 12, 13, 14, 15, 16 zugeordnet ist und folglich können auch nicht unmittelbar die beiden Wicklungen U, V, W angesteuert werden, die dem defekten Schalter 11, 12, 13, 14, 15, 16 nicht zugeordnet sind. Es wird daher damit begonnen, dass zwei der drei Wicklungen U, V, W angesteuert werden und sofern die Erkennungseinheit wieder einen Defekt erkennt, wird das Verfahren abgebrochen und bei einem Neustart des Verfahrens werden zwei andere der drei Wicklungen U, V, W angesteuert. Diese Wiederholung wird anhand des Ablaufdiagramms in Fig. 5 näher erläutert. Zu Beginn steht ein Fehlerzähler Z auf Null. Der Fehlerzähler Z erhöht seinen Wert um den Betrag "1", wenn die Erkennungseinheit A einen Defekt erkannt hat. Das in Fig. 5 dargestellte Ablaufdiagramm geht davon aus, dass die Erkennungseinheit A einen Defekt eines der Schalter 11, 12, 13, 14, 15, 16 erkannt hat. Im Verfahrensschritt 21 wird der Fehlerzahler um einen Wert erhöht: Z = Z+1.

Im Verfahrensschritt 22 werden alle Schalter 11, 12, 13, 14, 15, 16 geöffnet, sodass sie sich in der geöffneten Schalterstellung befinden. Nachfolgend wird im Verfahrensschritt 23 geprüft und unterschieden, welchen Wert der Fehlerzähler Z aufweist. Im vorliegenden Fall beträgt der Wert des Fehlerspeichers Z=1 und die Wicklung V wird mit einer pulsweitenmodulierten Spannung mit einem Tastverhältnis von PWM₁=33% und die Wicklung W mit PWM₂=66% beaufschlagt (Verfahrensschritt 24). An der Wicklung U wird später die dort anliegende Spannung gemessen. Im Verfahrensschritt 25 wird nun geprüft, ob die Erkennungseinheit A weiterhin einen defekten Schalter 11, 12, 13, 14, 15, 16 erkennt. Das ist ein Zeichen dafür, dass sich der defekte Schalter 11, 12, 13, 14, 15, 16 einer der angesteuerten Wicklungen V, W zugeordnet ist. Falls die Erkennungseinheit A einen Defekt erkennt, wird das Verfahren abgebrochen und der Fehlerzähler wird im Verfahrensschritt 21 um einen Wert erhöht. Falls kein Defekt von der Erkennungseinheit A erkannt wird, ist der defekte Schalter 13, 16 der nicht angesteuerten Wicklung U zugeordnet. Es erfolgt im Verfahrensschritt 26 eine Messung der an der Wicklung U anliegenden Spannung Bwmₘₑₛₛ und die anhand der Fig. 2 bis 4 beschriebenen Fälle werden unterschieden: Liegt an der Wicklung U eine Spannung von PWMₘₑₛₛ=0% an, so wird auf einen leitend defekten Schalter 16 mit Verbindung zur negativen Versorgungsspannung erkannt (Verfahrensschritt 27), der der Wicklung U zugeordnet ist. Die entspricht dem Defekt F₃, der anhand von Fig. 4 beschrieben wurde. Beträgt das Messergebnis dagegen PWMₘₑₛₛ=100%, so wird im Verfahrensschritt 28 ein leitend defekter Schalter 13 mit Verbindung zur positiven Versorgungsspannung erkannt, der der Wicklung U zugeordnet ist. Dies entspricht dem Defekt F₂, der anhand von Zig. 3 beschrieben wurde. In beiden Fällen kann der defekte Schalter 13, 16 durch eine gezielte thermische Überlast geöffnet werden oder es wird eine nicht dargestellte Sicherung geöffnet. Anschließend wird der Elektromotor in einem Notbetrieb betrieben, wie es Verfahrensschritt 30 vorsieht.

Wird dagegen ein Messergebnis 33%< PWMₘₑₛₛ < 66% also ein Messergebnis zwischen 33% und 66% ermittelt, so handelt es sich bei dem Defekt um einen nicht leitend defekten Schalter 13, 16, der der Wicklung U zugeordnet ist. Dabei handelt es sich um den Defekt E₁, der anhand von Fig. 2 beschrieben wurde. Wie bereits erwähnt kann in diesem Fall der Elektromotor 1 in einem Notbetrieb betrieben werden.

Wurde im Verfahrensschritt 25 ein Defekt mit Hilfe der Erkennungseinheit A erkannt, so muss es sich um einen Schalter 11, 12, 14, 15 in den angesteuerten Wicklungen V, W handeln. Der Fehlerzähler Z wird also im Verfahrensschritt 21 um einen Wert erhöht und im Verfahrensschritt 22 werden alle Schalter 11, 12, 13, 14, 15, 16 geöffnet. Die Abfrage nach dem Wert des Fehlerzählers führt mit einem Wert von Z=2 zum Verfahrensschritt 31. In diesem Verfahrensschritt 31 werden die Wicklung U mit einer pulsweitenmodulierten Spannung mit einem Tastverhältnis von PWM₁=33% und die Wicklung W mit PWM₂=66% beaufschlagt. An der Wicklung V wird nachfolgend eine Spannungsmessung vorgenommen. Im Verfahrensschritt 32 wird geprüft, ob die Erkennungseinheit A einen Defekt erkennt. Falls nein wird die an der Wicklung V anliegende Spannung im Verfahrensschritt 33 gemessen und bei einem Messergebnis von PWMₘₑₛₛ=0% wird der Defekt F₃, also ein leitend defekter Schalter 14 mit Verbindung zur negativen Versorgungsspannung erkannt, der der Wicklung V zugeordnet ist (Verfahrensschritt 34). Bei einem Messergebnis von PWMₘₑₛₛ=100% wird im Verfahrensschritt 35 der Defekt F2, also ein leitend defekter Schalter 11 mit Verbindung zur positiven Versorgungsspannung erkannt, der der Wicklung V zugeordnet ist. Und falls das Messergebnis PWMₘₑₛₛ zwischen 33% und 66% liegt, wird der Defekt F₁, also ein nicht leitend defekter Schalter 11, 14 erkannt, der der Wicklung V zugeordnet ist (Verfahrensschritt 36). In jedem Fall kann im Schritt 37 ein Notbetrieb des Elektromotors 1 aufgenommen werden - in den beiden zuerst genannten Fällen erst, nachdem der leitende Defekt geöffnet wurde.

Falls im Verfahrensschritt 32 ein weiterer Defekt erkannt wurde, springt das Verfahren zum Verfahrensschritt 21 zurück und erhöht den Fehlerzähler Z um den Wert "1". Das Verfahren springt deshalb zurück zum Verfahrensschritt 21, weil die Erkennungseinheit A in einem Schalter 12, 13, 15, 16, die den angesteuerten Wicklungen U und W zugeordnet sind, einen Defekt erkannt hat. Folglich beträgt nun der Wert des Fehlerzähler Z=3 und wie es in Fig. 5 dargestellt ist, wird das Verfahren wiederholt. Einziger Unterschied ist, dass nun die Wicklung U und die Wicklung V angesteuert werden, da nunmehr der defekte Schalter 12, 15 derjenige Schalter 12, 15 sein müsste, der der Wicklung W zugeordnet ist, da die Wicklung W die Letzte der drei Wicklungen U, V, W ist, die bislang keiner Spannungsmessung unterzogen wurde, während die anderen Wicklungen U, V angesteuert wurden.

Erkennt auch hier die Erkennungseinheit A einen Schalterdefekt, so liegt ein Mehrfachfehler vor, bei dem mehrere Schalter 11, 12, 13, 14, 15, 16 defekt sind. Das Verfahren springt zum Verfahrensschritt 21 zurück und der Fehlerzähler wird um den Wert "1" erhöht. Damit beträgt der Wert des Fehlerzählers Z=4. Dieser Wert des Fehlerzählers Z bedeutet, dass nicht nur ein Schalter 11, 12, 13, 14, 15, 16 defekt ist, sondern mehrere der Schalter 11, 12, 13, 14, 15, 16. Beim Vorliegen eines Mehrfachfehlers wird der Elektromotor 1 abgeschaltet.

Der Vorteil des beschriebenen Verfahrens ist darin zu sehen, dass nach der Lokalisierung und Erkennung des Defekts F₁, F₂, F₃ bedarfsgemäß ein Notbetrieb des Elektromotors 1 gestartet werden kann, falls der Schalter 11, 12, 13, 14, 15, 16 nicht leitend defekt ist, oder der Elektromotor 1 abgeschaltet werden kann oder eine Deaktivierung eines defekten leitenden Schalters 11, 12, 13, 14, 15, 16 eingeleitet werden kann, entweder durch eine gezielte thermische Überlast oder durch das Öffnen einer Sicherung. Hierfür wird auch die Information benötigt, ob sich der defekte Schalter 11, 12, 13, 14, 15, 16 der positiven oder der negativen Versorgungsseite zugeordnet ist. Nach dieser Deaktivierung des defekten Schalters 11, 12, 13, 14, 15, 16 kann ebenfalls ein Notbetrieb des Elektromotors 1 gestartet werden.

Das beschriebene Verfahren zeichnet sich vor allem dadurch aus, dass zur Lokalisierung und Erkennung eines defekten Schalters 11, 12, 13, 14, 15, 16 keine Stromsensoren notwendig sind und somit die Kosten verringert werden. Ein weiterer Vorteil besteht darin, dass ein Notbetrieb des Elektromotors 1 im Fehlerfall ermöglicht wird und somit die Verfügbarkeit des Elektromotors 1 erhöht wird, was in sicherheitskritischen Anwendungen wie einer elektromechanischen Lenkung vorteilhaft ist. Die Erkennung des defekten Schalters 11, 12, 13, 14, 15, 16 kann vergleichsweise schnell durchgeführt werden, so dass in sicherheitskritischen Anwendungen eine ausreichend schnelle Reaktion durchgeführt werden kann.

## Patentansprüche

1. Verfahren zum Betrieb eines bürstenlosen Elektromotors (1), dessen Wicklungen (U, V, W) von einem Wechselrichter (2) mit Hilfe von sechs Schalter (11, 12, 13, 14, 15, 16) angesteuert werden, wobei eine Erkennungseinheit (A) zum Erkennen von defekten Schaltern (11, 12, 13, 14, 15, 16), eine Einheit (B) zur Spannungsmessung an den Ausgängen (17, 18, 19) des Wechselrichters (2) und ein Mikrocontroller (C) zum Steuern der Schalter (11, 12, 13, 14, 15, 16) vorgesehen ist, **dadurch gekennzeichnet, dass** die von einem Defekt (F₁, F₂, F₃) betroffene Wicklung (U, V, W) lokalisiert wird und die Art des Defekts (F₁, F₂, F₃) der Schalter (13, 16) ermittelt wird, indem die Wicklungen (V, W), die nicht dem defekten Schalter (11, 12, 14, 15) zugeordnet sind, mit einer unterschiedlichen Spannung (PWM₁, PWM₂) angesteuert werden, während an der Wicklung (U), die dem defekten Schalter (13, 16) zugeordnet ist, eine Spannungsmessung durchgeführt wird.

2. Verfahren nach Anspruch 1, **dadurch gekennzeichnet, dass** die dem defekten Schalter (13, 16) zugeordnete Wicklung (U) mit der Einheit (B) zur Spannungsmessung verbunden wird.

3. Verfahren nach Anspruch 1 oder 2, **dadurch gekennzeichnet, dass** die Art des Defekts (F₁, F₂, F₃) ein in der geöffneten oder geschlossenen Schalterstellung blockierter Schalter (11, 12, 13, 14, 15, 16) ist.

4. Verfahren nach einem der vorhergehenden Ansprüche **gekennzeichnet durch** die folgenden Schritte:
- Erkennen eines defekten Schalters (13, 16) **durch** die Erkennungseinheit (A);
- Öffnen aller Schalter (11, 12, 13, 14, 15, 16);
- Ansteuern der Wicklungen (V, W), die dem defekten Schalter (13, 16) nicht zugeordnet sind mit unterschiedlichen Spannungen (PWM₁, PWM₂) und
- Messen und Auswerten der an der Wicklung (U) anliegenden Spannung, die dem defekten Schalter (13, 16) zugeordnet ist.

5. Verfahren nach Anspruch 4, **dadurch gekennzeichnet, dass** eine Wicklung (V), die dem defekten Schalter (13, 16) nicht zugeordnet ist, mit einer pulsweitenmodulierten Spannung (PWM₁) beaufschlagt wird, die ein Tastverhältnis von 1/3=33% aufweist während die andere Wicklung (W), die dem defekten Schalter (13, 16) ebenfalls nicht zugeordnet ist, mit einer pulsweitenmodulierten Spannung (PWM₂) beaufschlagt wird, die ein Tastverhältnis von 2/3=66% aufweist.

6. Verfahren nach Anspruch 5, **dadurch gekennzeichnet, dass** der Schalter (13, 16) als defekt in der geöffneten Schalterstellung erkannt wird, wenn das Messergebnis (PWMₘₑₛₛ) der pulsweitenmodulierten Spannung an der Wicklung (U), die dem defekten Schalter (13, 16) zugeordnet ist, ein Tastverhältnis zwischen 33% und 66% ergibt.

7. Verfahren nach Anspruch 5 oder 6, **dadurch gekennzeichnet, dass** der Schalter (13, 16) als defekt in der geschlossenen Schalterstellung mit Verbindung zur positiven Versorgungsspannung erkannt wird, wenn das Messergebnis (PWMₘₑₛₛ) der pulsweitenmodulierten Spannung an der Wicklung (U), die dem defekten Schalter (13, 16) zugeordnet ist, ein Tastverhältnis von 100% ergibt.

8. Verfahren nach Anspruch 5 oder 6, **dadurch gekennzeichnet, dass** der Schalter (13, 16) als defekt in der geschlossenen Schalterstellung mit Verbindung zur negativen Versorgungsspannung erkannt wird, wenn das Messergebnis (PWMₘₑₛₛ) der pulsweitenmodulierten Spannung an der Wicklang (U), die dem defekten Schalter (13, 16) zugeordnet ist, ein Tastverhältnis von 0% ergibt.

9. Verfahren nach einem der Ansprüche 4 bis 8, **dadurch gekennzeichnet, dass** die Verfahrensschritte so lange mit der Ansteuerung unterschiedlicher Wicklungen (U, V, W) wiederholt werden bis der Defekt (F₁, F₂, F₃) lokalisiert ist oder ein Mehrfachfehler erkannt wird bei dem mehrere Schalter (11, 12, 13, 14, 15, 16) defekt sind.

10. Verfahren nach einem der vorhergehenden Ansprüche, **dadurch gekennzeichnet, dass** der defekte Schalter (11, 12, 13, 14, 15, 16) für den Fall, dass der defekte Schalter (11, 12, 13, 14, 15, 16) im leitenden Zustand blockiert ist, durch eine gezielte thermische Überlast geöffnet wird.

11. Verfahren nach einem der Ansprüche 1 bis 4, **dadurch gekennzeichnet, dass** eine Sicherung geöffnet wird, falls der defekte Schalter (11, 12, 13, 14, 15, 16) in der geschlossenen Schalterstellung blockiert ist.

12. Verfahren nach einem der Ansprüche 1 bis 4, **dadurch gekennzeichnet, dass** der Elektromotor (1) abgeschaltet oder in einem Notbetrieb betrieben wird.

## Claims

1. Method for operating a brushless electric motor (1) whose windings (U, V, W) are driven by an inverter (2) with the aid of six switches (11, 12, 13, 14, 15, 16), with an identification unit (A) being provided in order to identify defective switches (11, 12, 13, 14, 15, 16), with a unit (B) being provided for voltage measurement at the outputs (17, 18, 19) of the inverter (2), and with a microcontroller (C) being provided for controlling the switches (11, 12, 13, 14, 15, 16), **characterized in that** the winding (U, V, W) which is affected by a defect (F₁, F₂, F₃) is traced and the nature of the defect (F₁, F₂, F₃) in the switches (13, 16) is determined by using a different voltage (PWM₁, PWM₂) to drive those windings (V, W) which are not associated with the defective switch (11, 12, 14, 15), while a voltage measurement is carried out on the winding (U) which is associated with the defective switch (13, 16).

2. Method according to Claim 1, **characterized in that** the winding (U) which is associated with the defective switch (13, 16) is connected to the unit (B) for voltage measurement.

3. Method according to Claim 1 or 2, **characterized in that** the nature of the defect (F₁, F₂, F₃) is a switch (11, 12, 13, 14, 15, 16) which is blocked in the open or closed switch position.

4. Method according to one of the preceding claims, **characterized by** the following steps:
- identification of a defective switch (13, 16) by the identification unit (A);
- opening of all the switches (11, 12, 13, 14, 15, 16);
- driving the windings (V, W) which are not associated with the defective switch (13, 16) with different voltages (PWM₁, PWM₂) and
- measurement and evaluation of the voltage which is applied to the winding (U) which is associated with the defective switch (13, 16).

5. Method according to Claim 4, **characterized in that** a winding (V) which is not associated with the defective switch (13, 16) has a pulse-width-modulated voltage (PWM₁) applied to it, which has a duty ratio of 1/3=33%, while the other winding (W) which is likewise not associated with the defective switch (13, 16) has a pulse-width-modulated voltage (PWM₂) applied to it which has a duty ratio of 2/3=66%.

6. Method according to Claim 5, **characterized in that** the switch (13, 16) is identified as defective in the open switch position if the measurement result (PWMₘₑₐₛ) of the pulse-width-modulated voltage on the winding (U) which is associated with the defective switch (13, 16) indicates a duty ratio between 33% and 66%.

7. Method according to Claim 5 or 6, **characterized in that** the switch (13, 16) is identified as being defective in the closed switch position with a connection to the positive supply voltage if the measurement result (PWMₘₑₐₛ) of the pulse-width-modulated voltage on the winding (U) which is associated with the defective switch (13, 16) indicates a duty ratio of 100%.

8. Method according to Claim 5 or 6, **characterized in that** the switch (13, 16) is identified as defective in the closed switch position with a connection to the negative supply voltage if the measurement result (PWMₘₑₐₛ) of the pulse-width-modulated voltage on the winding (U) which is associated with the defective switch (13, 16) indicates a duty ratio of 0%.

9. Method according to one of Claims 4 to 8, **characterized in that** the method steps are repeated, with different windings (U, V, W) being driven, until the defect (F₁, F₂, F₃) has been traced or a multiple fault is identified, in which a plurality of switches (11, 12, 13, 14, 15, 16) are defective.

10. Method according to one of the preceding claims, **characterized in that** the defective switch (11, 12, 13, 14, 15, 16) is opened by deliberate thermal overloading in the situation in which the defective switch (11, 12, 13, 14, 15, 16) is blocked in the switched-on state.

11. Method according to one of Claims 1 to 4, **characterized in that** a fuse is blown if the defective switch (11, 12, 13, 14, 15, 16) is blocked in the closed switch position.

12. Method according to one of Claims 1 to 4, **characterized in that** the electric motor (1) is switched off or is operated in an emergency mode.

## Revendications

1. Procédé de fonctionnement d'un moteur électrique sans balais (1), dont les enroulements (U, V, W) sont commandés par un onduleur (2) à l'aide de six commutateurs (11, 12, 13, 14, 15, 16), une unité de détection (A) destinée à détecter les commutateurs (11, 12, 13, 14, 15, 16) défectueux, une unité (B) de mesure de la tension aux sorties (17, 18, 19) de l'onduleur (2) et un microcontrôleur (C) destiné à commander les commutateurs (11, 12, 13, 14, 15, 16) étant prévus, **caractérisé en ce que** l'enroulement (U, V, W) concerné par un défaut (F₁, F₂, F₃) est localisé et la nature du défaut (F₁, F₂, F₃) du commutateur (13, 16) est déterminée en commandant les enroulements (V, W) qui ne sont pas associés au commutateur (11, 12, 14, 15) défectueux avec une tension différente (PWM₁, PWM₂), alors qu'une mesure de tension est effectuée sur l'enroulement (U) qui est associé au commutateur défectueux (13, 16).

2. Procédé selon la revendication 1, **caractérisé en ce que** l'enroulement (U) qui est associé au commutateur défectueux (13, 16) est relié avec l'unité (B) destinée à mesurer la tension.

3. Procédé selon la revendication 1 ou 2, **caractérisé en ce que** la nature du défaut (F₁, F₂, F₃) est un commutateur (11, 12, 13, 14, 15, 16) bloqué dans la position de commutateur ouverte ou fermée.

4. Procédé selon l'une des revendications précédentes, **caractérisé par** les étapes suivantes :
- détection d'un commutateur défectueux (13, 16) par l'unité de détection (A) ;
- ouverture de tous les commutateurs (11, 12, 13, 14, 15, 16) ;
- commande des enroulements (V, W) qui ne sont pas associés au commutateur défectueux (13, 16) avec des tensions différentes (PWM₁, PWM₂) et
- mesure et interprétation de la tension appliquée à l'enroulement (U) qui est associé au commutateur défectueux (13, 16).

5. Procédé selon la revendication 4, **caractérisé en ce qu'**un enroulement (V) qui n'est pas associé au commutateur défectueux (13, 16) est soumis à une tension modulée en largeur d'impulsion (PWM₁) qui présente un rapport cyclique de 1/3 = 33 %, alors que l'autre enroulement (W) qui n'est pas non plus associé au commutateur défectueux (13, 16) est soumis à une tension modulée en largeur d'impulsion (PWM₂) qui présente un rapport cyclique de 2/3 = 66 %.

6. Procédé selon la revendication 5, **caractérisé en ce que** le commutateur (13, 16) est détecté comme étant défectueux dans la position de commutateur ouverte lorsque le résultat de la mesure (PWMₘₑₛₛ) de la tension modulée en largeur d'impulsion aux bornes de l'enroulement (U) qui est associé au commutateur défectueux (13, 16) produit un rapport cyclique compris entre 33 % et 66 %.

7. Procédé selon la revendication 5 ou 6, **caractérisé en ce que** le commutateur (13, 16) est détecté comme étant défectueux dans la position de commutateur fermée en liaison avec la tension d'alimentation positive lorsque le résultat de la mesure (PWMₘₑₛₛ) de la tension modulée en largeur d'impulsion aux bornes de l'enroulement (U) qui est associé au commutateur défectueux (13, 16) produit un rapport cyclique de 100 %.

8. Procédé selon la revendication 5 ou 6, **caractérisé en ce que** le commutateur (13, 16) est détecté comme étant défectueux dans la position de commutateur fermée en liaison avec la tension d'alimentation négative lorsque le résultat de la mesure (PWMₘₑₛₛ) de la tension modulée en largeur d'impulsion aux bornes de l'enroulement (U) qui est associé au commutateur défectueux (13, 16) produit un rapport cyclique de 0 %.

9. Procédé selon l'une des revendications 4 à 8, **caractérisé en ce que** les étapes du procédé sont répétées en commandant des enroulements (U, V, W) différents jusqu' à ce que le défaut (F₁, F₂, F₃) soit localisé et qu'un défaut multiple soit détecté, dans lequel plusieurs commutateurs (11, 12, 13, 14, 15, 16) sont défectueux.

10. Procédé selon l'une des revendications précédentes, **caractérisé en ce que** le commutateur (11, 12, 13, 14, 15, 16) défectueux, dans le cas où le commutateur (11, 12, 13, 14, 15, 16) défectueux est bloqué à l'état passant, est ouvert par une surcharge thermique ciblée.

11. Procédé selon l'une des revendications 1 à 4, **caractérisé en ce qu'**un fusible est ouvert dans le cas où le commutateur (11, 12, 13, 14, 15, 16) défectueux est bloqué dans la position de commutateur fermée.

12. Procédé selon l'une des revendications 1 à 4, **caractérisé en ce que** le moteur électrique (1) est mis hors circuit ou fonctionne dans un mode de secours.
